Europäisches Patentamt

European Patent Office

Office européen des brevets

(19)

(11) Publication number: **0 343 797**
**A1**

## (12) EUROPEAN PATENT APPLICATION

(21) Application number: **89304338.0**

(22) Date of filing: **28.04.89**

(51) Int. Cl.⁴: **H01L 29/74 , H01L 29/743 , H01L 29/06**

(30) Priority: **25.05.88 US 198764**

(43) Date of publication of application:
**29.11.89 Bulletin 89/48**

(84) Designated Contracting States:
**DE FR GB**

(71) Applicant: **POWEREX, INC.**
**Hillis Street**
**Youngwood Pennsylvania 15697(US)**

(72) Inventor: **Miller, Donald L.**
**17 Pheasant Run Drive**
**Export Pennsylvania 15632(US)**
Inventor: **Leslie, Scott G.**
**11508 Clematis Boulevard**
**Pittsburgh Pennsylvania 15235(US)**

(74) Representative: **Bull, Michael Alan et al**
**Haseltine Lake & Co. Hazlitt House 28**
**Southampton Buildings Chancery Lane**
**London WC2A 1AT(GB)**

(54) **Field grading extension for enhancement of blocking voltage capability of high voltage thyristor.**

(57) The present invention pertains to a semiconductor device. The semiconductor device includes a semiconductor body. The semiconductor body has a first major surface and an opposing second major surface. The semiconductor device also is comprised of a field grading extension. The field grading extension contacts the first major surface of the semiconductor body and extends beyond the edge of the first major surface of the semiconductor body. The field grading extension is capable of decreasing electric field strength at the edge of the first major surface. The field grading extension is made of an electrically conductive material or a semiconducting material. There is also a cathode conductive layer and an anode conductive layer contacting the first and second major surfaces, respectively, of the semiconductor body. The semiconductor body can include a thyristor. The thyristor has a cathode emitter region and a cathode base region disposed adjacent the first major surface of the semiconductor body. The thyristor also has an anode emitter region and an anode base region disposed adjacent the second opposed major surface of the semiconductor body.

FIG. 1

## FIELD GRADING EXTENSION FOR ENHANCEMENT OF BLOCKING VOLTAGE CAPABILITY OF HIGH VOLTAGE THYRISTOR

The present invention relates to thyristors. More specifically, the present invention relates to a thyristor having a field grading extension which enhances the blocking voltage capability of the thyristor.

In the fabrication of high-voltage thyristors, or silicon controlled rectifiers (SCRs), special attention must be given to the termination of the p-n junctions which support the applied voltage in the blocking state. The standard approach is to mechanically bevel the side of the device so that the surface vector of the silicon is at an angle of 45-60 degrees with respect to the junction near the reverse blocking junction and at an angle of 1-5 degrees near the forward blocking junction. This is referred to as a positive-negative beveled structure, a positive bevel being one in which more silicon is removed from the lightly doped side of the junction and a negative bevel being one in which more silicon is removed from the heavily doped side of the junction. This approach works well for devices rated for voltages up to about 4000 volts. At higher voltages, the negative angle must be reduced to control the surface and subsurface fields near the intersection of the junction with the silicon surface. This leads to an unacceptable reduction in, the active area of the device. A second disadvantage of this approach is that electric fields below the surface of a negative bevel exceed those in the bulk, thus lowering the blocking voltage capability of the device.

A second alternative is the use of planar technology, which terminates the forward blocking junction at the first major surface of the device. High-voltage planar processing suffers from two drawbacks. First, planar devices are typically fabricated using boron diffusion rather than the standard gallium or aluminum-gallium diffusion. This impacts such device characteristics as switching times, conducting state voltage, and voltage rate of rise immunity. Second, in order to realize the full voltage blocking capability of the p-n junction guard rings must be used to distribute the equipotential contours. This again results in a reduction of active area available.

A third approach to junction termination is to contour the side of the device such that both the forward and reverse blocking junctions are beveled in the positive direction. This contour is referred to as a double-positive or sigma bevel. The use of positive bevels on both junctions maximizes the conducting area of the device while maintaining a high probability that the full blocking voltage capability of the junction will be realized.

Typically, in the above-identified thyristors, a passivating agent is applied to the intersection of the voltage blocking junctions and the silicon surface. This is required to prevent surface breakdown when voltage is applied to the device. In positive-negative and double-positive beveled devices, this passivating agent is typically an organic coating such as a silicone resin or an RTV. Impurities may be added to the passivating agent to provide a surface charge which further reduces the surface electric fields.

In the operation of the thyristor, a potential difference is applied between the anode and the cathode of the thyristor. Within the body of the device this potential is supported by a depletion region which spans the blocking junction. Outside the device this potential must be supported by the junction passivation and by the ambient within the device package. In any prudent design the device voltage will be limited by the breakdown voltage of the silicon, the coating being more than adequate to support any applied voltage. Unfortunately, organic coatings have limited dielectric strength, which degrades when they are used at high temperatures or when ionic impurities are added. In addition, if the local electric field exceeds the dielectric strength of the organic coating catastrophic breakdown will occur. This is, in fact, a common failure mode of high-voltage thyristors which employ double-positive junction termination.

The present invention pertains to a semiconductor device. The semiconductor device comprises a semiconductor body. The semiconductor body has a first major surface and an opposing second major surface. The semiconductor device also is comprised of a field grading extension. The field grading extension contacts the first major surface of the semiconductor body and extends beyond the edge of the first major surface of the semiconductor body. The field grading extension is made of an electrically conductive material. There is also a cathode conductive layer and an anode conductive layer contacting the first and second major surfaces, respectively, of the semiconductor body. In a preferred embodiment, there is a thyristor disposed in the semiconductor body. The thyristor has a cathode emitter region and a cathode base region disposed adjacent the first major surface of the semiconductor body. The thyristor also has an anode emitter region and an anode base region disposed adjacent the second opposed major surface of the semiconductor body.

In a more preferred embodiment, the field grading extension is contiguous to and electrically in contact with the first major surface of the semiconductor body and has a minimum radius of curvature larger than that of the edge of the first major surface of the semiconductor body. The field grading extension is ring shaped and the semiconductor body has a double-positive bevel. A dielectric coating is disposed along the double-positive bevel.

Other details, objects and advantages of the invention will become apparent as the following description of the presently preferred embodiments and presently preferred methods of practicing the invention proceeds.

In the accompanying drawing, preferred embodiments of the invention and preferred methods of practicing the invention are illustrated, in which:

Figure 1 is a side view of a portion of the semiconductor device having a double bevel.

Figure 2 is a side view of a portion of the semiconductor body device having a single bevel.

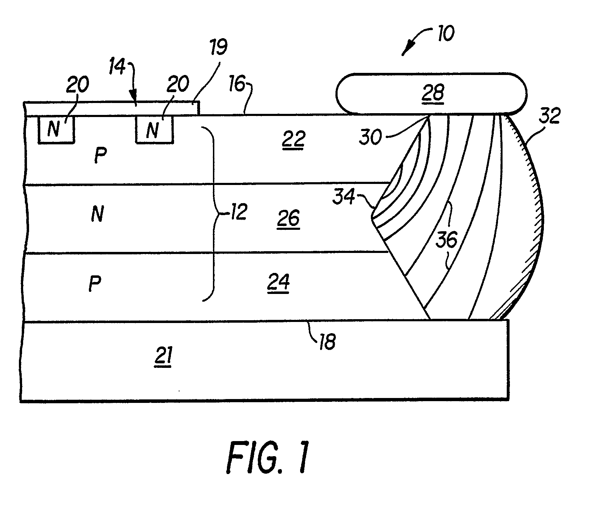

Referring now to Figure 1, there is shown a side view of a portion of a semiconductor device 10. The semiconductor device 10 is comprised of a semiconductor body 14. The semiconductor body 14 has a first major surface 16 and an opposing second major surface 18. The semiconductor device 10 also is comprised of a field grading extension 28 which contacts the first major surface 16 and extends beyond the edge 30 of the first major surface 16 of the semiconductor body 14. The field grading extension 28 is made of an electrically conducting material such as aluminum or of a semiconducting material such as silicon. The field grading extension 28 is capable of decreasing electric field strength at the edge 30 of the first major surface 16 of the semiconductor body 14 compared to a similar semiconductor body without a field grading extension 28.

Preferably, the semiconductor body 14 is comprised of a thyristor 12, although it can be comprised of diode or a transistor. The thyristor 12 has a cathode emitter region 20 and a cathode base region 22 disposed adjacent the first major surface 16 of the semiconductor body 14. The thyristor 12 also has an anode emitter region 24 and an anode base region 26 disposed adjacent the second opposing major surface 18 of the semiconductor body 14.

The semiconductor device 10 also is comprised of a cathode conductive layer 19 and an anode conductive layer 21 contacting the first and second major surfaces, respectively, of the semiconductor body 14. The anode conductive layer 21 is made of either tungsten or preferably molybdenum. The cathode conductive layer 19 is preferably made of aluminum.

Preferably, the field grading extension 28 is contiguous to and electrically in contact with the first major surface 16 of the semiconductor body 14. The field grading extension 28 serves to extend the edge 30 of the first major surface 16 on the semiconductor body 14. Preferably, the field grading extension 28 has a radius of curvature larger than that of the edge 30 of the first major surface 16 of the semiconductor body 14. Consequently, when the field grading extension is positioned in place with respect to the edge 30, the edge 30 is essentially extended by the field grading extension. The effective radius of curvature of the edge 30 with respect to the electric field is then the radius of curvature of the field grading extension 28.

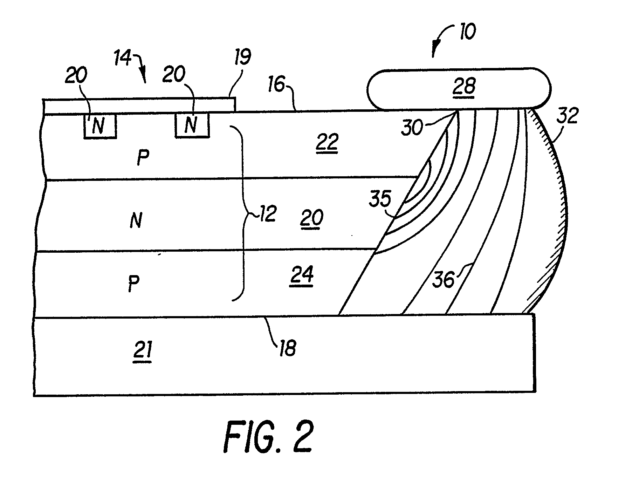

The semiconductor body 14 preferably has a double positive bevel 34, although a single bevel 35 can also be used, as shown in Figure 2. A dielectric coating 32 is disposed along the double positive bevel 34, or the single bevel 35 with respect to that embodiment.

The field grading extension also provides an additional benefit. The field grading extension 28 acts as a mechanical buffer to protect the fragile edge 30 of a double positive beveled semiconductor body 14 from chipping due to accidental impact during testing, packaging or handling.

In the operation of the invention, when a potential difference is applied across the semiconductor device 10, an electric field is believed to be created such that electric field lines 36 emanate from the anode emitter region 24 and anode base region 26 sections along the double-positive bevel 32 of the semiconductor body 14. These emanating electric field lines 36 are received by and distributed along both the forward blocking junction, (defined by the anode base region 26 and cathode base region 22) and the portion of the field grading extension 28 that extends beyond the edge 30 of the first major surface 16 of the semiconductor body 14. (The electric field lines 36 depict the electric field that is present in the region of the double-positive bevel 34 when a voltage is applied across the semiconductor device 10). The field grading extension 28 effectively moves any region of electric field crowding away from the semiconductor body 14, relative to a similar semiconductor body 14 without a field grading extension 28, due to the field grading extension 28 extending the edge 30. The device 10 is then able to withstand much greater voltages across the semiconductor body 14 than is possible without the field grading extension 28 before electric field strength is built up near the edge 30 of the first major surface 16 of the semiconductor body 14 and catastrophic breakdown occurs.

Although the invention has been described in detail in the foregoing for the purpose of illustration, it is to be understood that such detail is solely for that purpose and that variations can be made therein by those skilled in the art without departing from the spirit and scope of the invention as described in the following claims.

## Claims

1. A semiconductor device comprising:
a thyristor disposed in a semiconductor body, said semiconductor body having a first major surface and opposing second major surface, said thyristor having a cathode emitter region and a cathode base region disposed adjacent the first major surface of the semiconductor body, and an anode emitter region and an anode base region disposed adjacent the second opposed major surface of the semiconductor body; ·
a field grading extension contacting the first major surface and extending beyond the edge of the first major surface, said field grading extension being made of an electrically conducting material and is capable of decreasing electric field strength at the edge of the first major surface; and
a cathode conductive layer and an anode conductive layer contacting the first and second major surfaces, respectively, of the semiconductor body.

2. A semiconductor device comprising:
a thyristor disposed in a semiconductor body, said semiconductor body having a first major surface and opposing second major surface, said thyristor having a cathode emitter region and a cathode base region disposed adjacent the first major surface of the semiconductor body, and an anode emitter region and an anode base region disposed adjacent the second opposed major surface of the semiconductor body and is capable of decreasing electric field strength at the edge of the first major edge of the first major surface; and
a field grading extension contacting the first major surface and extending beyond the edge of the first major surface, said field grading extension being made of a semiconducting material.

3. A semiconductor device as described in Claims 1 and 2 wherein the field grading extension is contiguous to and electrically in contact with the first major surface and has a radius of curvature larger than that of the edge of the first major surface of the semiconductor body.

4. A semiconductor device as described in Claim 2 wherein the semiconductor body has a double-positive bevel.

5. A semiconductor device as described in Claim 4 wherein a dielectric coating is disposed along the double-positive bevel.

6. A semiconductor device as described in Claim 3 wherein the semiconductor body has a double-positive bevel.

7. A semiconductor device as described in Claim 6 wherein a dielectric coating is disposed along the single bevel.

8. A semiconductor device comprising:
a semiconductor body, said semiconductor body having a first major surface and opposing second major surface; and
a field grading extension contacting the first major surface and extending beyond the edge of the first major surface, said field grading extension being made of an electrically conducting material and is capable of decreasing electric field strength at the edge of the first major surface.

9. A semiconductor device comprising:

a semiconductor body, said semiconductor body having a first major surface and opposing second major surface; and
a field grading extension contacting the first major surface and extending beyond the edge of the first major surface, said field grading extension being made of a semiconducting material and is capable of decreasing electric field strength at the edge of the first major surface.

10. A semiconductor device as described in Claims 8 and 9 wherein the field grading extension is contiguous to and electrically in contact with the first major surface and has a radius of curvature larger than that of the edge of the first major surface of the semiconductor body.

FIG. 1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 235 706 (K. K. TOSHIBA) * abstract; page 5, column 1, lines 1-16; figure 2 * | 1,2,8,9 | H 01 L 29/74 H 01 L 29/743 H 01 L 29/06 |
| A | PATENT ABSTRACTS OF JAPAN vol. 4, no. 32 (E-2)(514) 19 March 1980; & JP - A - 55 6847 (MISUBISHI DENKI K.K.) 18.01.1980 * abstract; figure * | 1,2,8,9 | |
| A | GB-A-2 045 000 (WESTINGHOUSE ELECTRIC CORP.) * page 2, lines 36-40; figure 1 * | 1,2,7-9 | |
| A | EP-A-0 075 102 (SIEMENS AG) * abstract; figure 1 * | 4,6 | |
| A | DE-A-3 335 115 (MITSUBISHI DENKI K.K.) * page 4, line 16 - page 5, line 7 * | 5,7 | |
| A | EP-A-0 075 103 (SIEMENS AG) * figure 1; page 4, lines 3-12 * | 5,7 | TECHNICAL FIELDS SEARCHED (Int. Cl.4) H 01 L 29/00 |

The present search report has been drawn up for all claims

| Place of search | Date of completion of the search | Examiner |
|---|---|---|
| BERLIN | 11-08-1989 | JUHL A. |